# EUROPÄISCHE PATENTSCHRIFT

(11) **EP 3 422 512 B1**
(45) Veröffentlichungstag und Bekanntmachung des Hinweises auf die Patenterteilung: **07.02.2024**
(21) Anmeldenummer: 18168377.2
(22) Anmeldetag: 20.04.2018
(51) Int. Cl.: H02H 1/00, H02H 3/04, H01H 9/50, G01R 31/08

(54) **BRANDSCHUTZSCHALTER UND VERFAHREN**
FIRE PROTECTION SWITCH AND METHOD
COMMUTATEUR DE PROTECTION CONTRE L'INCENDIE ET PROCÉDÉ

(30) Priorität: 30.06.2017 DE 102017211121
(43) Veröffentlichungstag der Anmeldung: 02.01.2019
(73) Patentinhaber: Siemens Aktiengesellschaft, 80333 München (DE)
(72) Erfinder: Dhanraj, Vinod Gideon, 93059 Regensburg (DE); Hueber, Alexander, 84085 Niederleierndorf (DE); Martel, Jean-Mary, 93105 Tegernheim (DE); Mayer, Christian, 94327 Bogen (DE)
(74) Vertreter: Siemens Patent Attorneys

(56) Entgegenhaltungen:
- EP-A2- 2 899 821
- DE-A1-102015 218 914
- US-B1- 8 599 523

## Beschreibung

Die Erfindung betrifft einen Brandschutzschalter für einen elektrischen Dreiphasenwechselstromkreis nach dem Oberbegriff von Patentanspruch 1 und ein Verfahren nach dem Oberbegriff von Patentanspruch 7.

Brandschutzschalter sind relativ neuartige Schutzeinrichtungen für Stromkreise bzw. Energieversorgungsnetze und dienen zum Erkennen von Fehlerlichtbögen, wie parallele oder serielle (Fehler-)Lichtbögen. Brandschutzschalter werden auch als Arc Fault Detection Device, kurz AFDD, oder Arc Fault Circuit Interrupter, kurz AFCI, bezeichnet. Fehlerlichtbögen, manchmal auch als Störlichtbögen bezeichnet, können durch schlecht geklemmte elektrische Verbindungen in Verteilerdosen oder Steckdosen bzw. durch schlechte Isolierungen und Kontakte entstehen. Brandschutzschalter können insbesondere in Niederspannungsnetzen, z.B. in Hausinstallationseinrichtungen, wie Sicherungskästen, eingesetzt werden, um derartige Fehler zu erkennen und bei vorliegen eines Fehlers bzw. Überschreitung eines Fehlerlichtbogengrenzwertes den elektrischen Stromkreis zu unterbrechen.

Mit Niederspannung sind Spannungen bis 1000 Volt Wechselspannung oder/und 1500 Volt Gleichspannung gemeint. Mit Niederspannung sind insbesondere Spannungen gemeint, die größer als die Kleinspannung, mit Werten von 25 Volt oder 50 Volt Wechselspannung sowie 60 Volt oder 120 Volt Gleichspannung sind. Mit Stromkreisen, insbesondere für Niederspannung, sind insbesondere Stromkreise für Ströme bis zu 6300 Ampere gemeint, spezieller Ströme bis zu 1600 Ampere, 1200 Ampere, 630 Ampere, 125 Ampere oder 63 Ampere. Mit den genannten Stromwerten sind insbesondere Nenn- oder/und Abschaltströme gemeint, bei denen der elektrische Stromkreis üblicherweise unterbrochen wird, beispielsweise durch eine Schutzeinrichtung, wie dem Leitungsschutzschalter oder einem Leistungsschalter.

Mit Fehlerlichtbögen sind insbesondere Lichtbögen gemeint, sowohl serielle als auch parallele, die durch Fehler im Stromkreis entstehen. Lichtbögen, die regulär beim Schalten bzw. durch den Betrieb von gewünschten elektrischen Verbrauchern entstehen, sind nicht gemeint. Derartige Lichtbögen werden auch als Schaltlichtbögen bezeichnet.

Ein serieller Störlichtbogen ist vorhanden, wenn ein Strom trotz Unterbrechung in einem elektrischen Leiter fließt und die Stromleitung an der Unterbrechungsstelle in Form eines leitfähigen Luftplasmas erfolgt.

Wenn ein Kurzschluss mit einem anderen Leiter ohne stabilen Kontakt Leiter zu Leiter auftritt, wird von einem parallelen Störlichtbogen gesprochen.

Parallele Störlichtbögen können z.B. durch Alterung des Isolationsmaterials oder Präsenz von leitender Verschmutzung zwischen Leitern verursacht werden.

Parallele Fehlerlichtbögen stellen eine fehlerhafte Verbindung zwischen den Anlageteilen (Leitern) unterschiedlichen Potentials her. Fehlerlichtbögen können zwischen zwei verschiedenen Phasenleitern, zwischen Phasenleiter (L) und Erdungsleiter (PE), oder zwischen Phasenleiter und Neutralleiter (N) auftreten.

Wenn von Phasen-, Erdungs- bzw. Neutralleiter gesprochen wird, bezieht sich das nicht nur auf die Leiter, sondern auch auf alle Anlagenteile mit gleichem Potential.

Häufig weisen Brandschutzschalter keine eigenen Trennmittel, wie Kontakte, zur Unterbrechung des elektrischen Stromkreises auf. Die Unterbrechung des elektrischen Stromkreises erfolgt hierbei durch mit dem Brandschutzschalter gekoppelte, wie mechanisch oder elektrisch gekoppelte, Leitungsschutzschalter. Derartige Leitungsschutzschalter werden auch als Miniatur Circuit Breaker bezeichnet.

In Dreiphasenwechselstromnetzen werden Brandschutzschalter noch nicht eingesetzt. Ihre Anwendung wäre aber sinnvoll, weil viele Verbraucher bzw. Lasten Drehphasenwechselstrom bzw. Drehstrom brauchen. Ein Nachteil derartiger drei- oder vierpoliger Brandschutzschalter für Dreiphasenwechselstromnetzen besteht darin, dass im Fehlerfalle nicht ersichtlich ist, worin der Fehler bestand.

Im Dokument DE 10 2015 218 914 A1 wird ein Brandschutzschalter für einen dreiphasigen Stromkreis angegeben. Strom- und Spannungswerte des Stromkreises werden fortlaufend ermittelt, digitalisiert und für einen bestimmten Zeitraum gespeichert. Dadurch kann im Fall einer Auslösung die Ausfallursache basierend auf einer Analyse der gespeicherten Daten ermittelt werden. Dabei kann auch eine fehlerhafte Phase identifiziert werden. Eine graphische Anzeige meldet relevante Daten.

Die Aufgabe der vorliegenden Erfindung besteht darin, einen Brandschutzschalter für Dreiphasenwechselstromnetze zu verbessern, insbesondere verbesserte Informationen zur Lokalisierung des Fehlers zu erhalten.

Diese Aufgabe wird durch einen Brandschutzschalter oder ein Verfahren gemäß den unabhängigen Patentansprüchen gelöst. Erfindungsgemäß ist ein Brandschutzschalter für einen elektrischen Dreiphasenwechselstromkreis mit 3 Phasenleitern nach Anspruch 1 vorgesehen.

Dies hat den besonderen Vorteil, dass eine Anzeige des Fehlerortes ermöglicht wird. Die Steuerungseinheit liefert die Information, an welcher der 3 Phasen der Fehler aufgetreten ist.

Vorteilhafte Ausgestaltungen der Erfindung sind in den Unteransprüchen angegeben.

Erfindungsgemäß weist außerdem der elektrische Dreiphasenwechselstromkreis einen Neutralleiter auf. Die Sensoreinheit bzw. Sensorteileinheit erfasst mindestens eine elektrische Größe des Neutralleiters. Die Anzeigeeinheit ist derart ausgestaltet, dass ein Phasen- oder/und Neutralleiterbezug des aufgetretenen Fehlerlichtbogens angezeigt wird.

Dies hat den besonderen Vorteil, dass bei Dreiphasenwechselstromkreisen mit Neutralleiter eine genaue Anzeige des Fehlerorts gegeben ist.

In einer vorteilhaften Ausgestaltung der Erfindung ist die Steuerungseinheit derart ausgestaltet, dass auch ein Fehlerlichtbogen gegen Erde ermittelbar ist. Die Anzeigeeinheit ist derart ausgestaltet, dass ein Erdbezug des aufgetretenen Fehlerlichtbogens anzeigbar ist.

Dies hat den besonderen Vorteil, dass eine weitere genaue Anzeige des Fehlerortes gegeben ist.

In einer vorteilhaften Ausgestaltung der Erfindung ist die Anzeigeeinheit derart ausgestaltet, dass neben dem Leiterbezug auch die Fehlerart des Fehlerlichtbogens angezeigt wird. Dies hat den besonderen Vorteil, dass nicht nur der Fehlerort, sondern auch die Fehlerart, d.h. ob ein serieller oder(und) paralleler Fehlerlichtbogen vorliegt, angezeigt wird. Die Steuerungseinheit liefert die Information, ob aufgrund eines seriellen oder parallelen Fehlerlichtbogens ausgelöst wurde. Ferner an welcher der 3 Phasen der Fehler aufgetreten ist.

In einer vorteilhaften Ausgestaltung der Erfindung ist die Anzeigeeinheit derart ausgestaltet, dass mindestens 3 Lichtemitterdioden, kurz LED, vorgesehen sind, insbesondere 4, 5, 6, 10 oder 13 LED vorgehsehen sind, mittels denen der Leiter- oder/und Erdbezug angezeigt wird.

Dies hat den besonderen Vorteil, dass eine direkte Ablesbarkeit des Fehlerorts oder/und der Fehlerart gegeben ist.

In einer vorteilhaften Ausgestaltung der Erfindung ist die Anzeigeeinheit derart ausgestaltet, dass mindestens eine, insbesondere zwei, Siebensegmentanzeigen vorgesehen sind, mittels denen der Leiter- oder/und Erdbezug angezeigt wird. Dies hat den besonderen Vorteil, dass eine weitere direkte Ablesbarkeit des Fehlerorts oder/und der Fehlerart gegeben ist.

In einer vorteilhaften Ausgestaltung der Erfindung ist die Anzeigeeinheit derart ausgestaltet, dass ein LCD Display vorgesehen ist, mittels dem der Leiter- oder/und Erdbezug angezeigt wird.

Dies hat den besonderen Vorteil, dass eine weitere direkte Ablesbarkeit des Fehlerorts oder/und der Fehlerart gegeben ist.

In einer vorteilhaften Ausgestaltung der Erfindung ist eine Unterbrechungseinheit mit Kontakten vorgesehen, die bei einem Fehlerlichtbogenerkennungssignal den elektrischen Dreiphasenwechselstromkreis unterbricht.

Dies hat den besonderen Vorteil, dass eine Unterbrechung des elektrischen Stromkreis durch eine im Brandschutzschalter integrierte Unterbrechungseinheit erfolgt. Eine externe Unterbrechungseinheit, beispielsweise durch einen Leitungsschutzschalter oder Leistungsschalter kann entfallen.

Erfindungsgemäß wird ferner ein paralleles Verfahren angegeben.

Alle Ausgestaltungen, sowohl in abhängiger Form rückbezogen auf den Patentanspruch 1, als auch rückbezogen lediglich auf einzelne Merkmale oder Merkmalskombinationen von Patentansprüchen, bewirken eine Verbesserung eines Brandschutzschalters.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit der Zeichnung näher erläutert werden.

Dabei zeigt die Zeichnung:
Figur 1 ein erstes Blockschaltbild eines erfindungsgemäßen Brandschutzschalters,
Figur 2 ein zweites Blockschaltbild eines erfindungsgemäßen Brandschutzschalters,
Figur 3 bis 6 auftretende Fehlerszenarien,
Figur 7 eine Darstellung mit zwei erfindungsgemäßen Brandschutzschaltern.

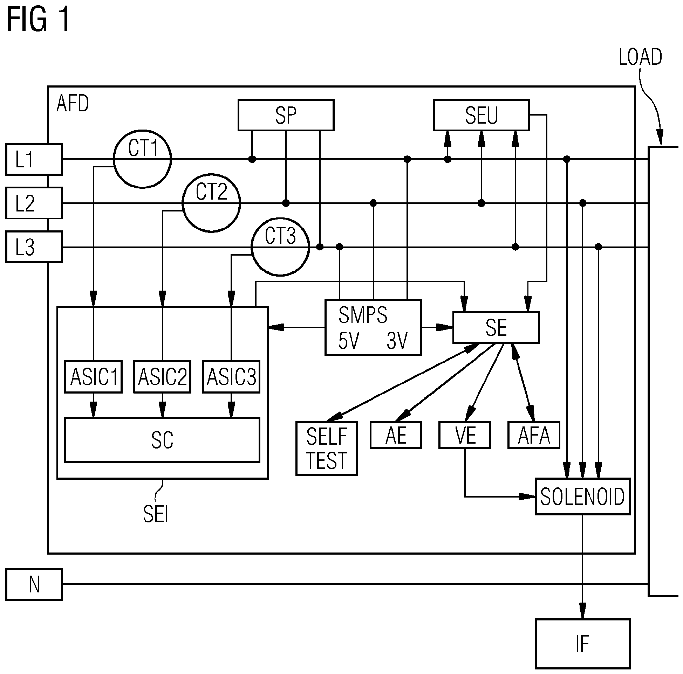

Figur 1 zeigt ein erstes Blockschaltbild eines erfindungsgemäßen Brandschutzschalters AFD. Diese weist drei energiequellenseitige Anschlüsse L1, L2, L3 für die 3 Phasenleiter eines Dreiphasenwechselstromkreises auf. Energiesenkenseitig sind die drei, den Brandschutzschalter AFD durchlaufenden Phasenleiter mit einer Energiesenke LOAD verbunden. Dem Brandschutzschalter AFD kann ein Leitungsschutzschalter MCB vor oder nachgeschaltet sein, zur Unterbrechung des elektrischen Stromkreises. Des Weiteren kann im Brandschutzschalter AFD eine Unterbrechungseinheit, beispielsweise mit Kontakten, zur Unterbrechung des elektrischen Stromkreises vorhanden sein. Beides ist nicht in Figur 1 dargestellt.

Den 3 Phasenleitern L1, L2, L3 ist eine Sensoreinheit zugeordnet. Beispielsweise kann die Sensoreinheit aus mehreren Sensorteileinheiten bestehen, wie beispielsweise einer ersten, zweiten und dritten Sensorteileinheit CT1, CT2, CT3 zur Erfassung von Stromgrößen des elektrischen Dreiphasenwechselstromkreises, einer vierten Sensorteileinheit SEU, zur Erfassung von Spannungsgrößen des Dreiphasenwechselstromkreises. Die vierte Sensorteileinheit SEU ist mit einer Steuerungseinheit SE des Brandschutzschalters AFD verbunden, so dass diese ermittelte Spannungsgrößen erhält.

Die vierte Sensorteileinheit SEU kann neben der Erfassung von Spannungsgrößen des Dreiphasenwechselstromkreises eine analoge oder/und digitale (Vor-)Verarbeitung der ermittelten Spannungen vornehmen.

Die erste, zweite und dritte Sensorteileinheit CT1, CT2, CT3 kann mit einer fünften Sensorteileinheit SEI zur Aufbereitung und (Vor-)Verarbeitung der ermittelten Stromgrößen verbunden sein. Diese fünfte Sensorteileinheit SEI kann eine Signalkonditionierungseinheit SC aufweisen, sowie applikationsspezifische Mikroprozessoren ASIC1, ASIC2, ASIC3 zur Aufbereitung ermittelter Stromgrößen.

Beispielsweise sind die erste, zweite und dritte Sensorteileinheit CT1, CT2, CT3 über die fünfte Sensorteileinheit SEI mit der Steuerungseinheit SE verbunden, so dass diese ermittelte Stromgrößen erhält.

Der Brandschutzschalter AFD weist ferner ein Netzteil SMPS zur Stromversorgung auf, beispielsweise ein (dreiphasiges) Schaltnetzteil, das z.B. mit den 3 Phasenleitern verbunden ist.

Dieses versorgt die Steuerungseinheit SE und gegebenenfalls weiter Funktionseinheiten, wie die Sensoreinheit bzw. Sensorteileinheit(en) mit Energie. Beispielsweise die Steuerungseinheit mit einer Spannung von 3 Volt und die Sensoreinheit bzw. Sensorteileinheit mit einer Spannung von 5 Volt.

Der Brandschutzschalter kann ein Überspannungsmodul SP aufweisen, wie ein so genanntes Surge Protection Modul.

Dies Steuerungseinheit SE weist mindestens eine Fehlerlichtbogenerkennungsfunktion AFA auf. Diese ermittelt aus den ermittelten Strom- und Spannungsgrößen, die wahlweise im niederfrequenten- oder/und hochfrequenten Bereich ermittelt wurden, etwaige serielle oder/und parallele Fehlerlichtbögen, nach bekannten Algorithmen.

Dabei ist die Steuerungseinheit SE bzw. die Fehlerlichtbogenerkennungsfunktion AFA derart ausgestaltet, dass die Fehlerlichtbögen pro Phasenleiter ermittelt werden oder ein Bezug der Fehlerlichtbogens zum Phasenleiter bzw. den Phasenleitern ermittelt wird, so dass eine Information zur Verfügung steht, in welchem Phasenleiter(n) ein Fehlerlichtbogen auftritt. Dies kann beispielsweise durch eine parallele Auswertung aller Phasenleiter durch entsprechende parallele Fehlerlichtbogenerkennungsfunktionen erfolgen. Alternativ kann auch eine serielle Auswertung der Phasenleiter durch eine Fehlerlichtbogenerkennungsfunktionen erfolgen, d.h. nacheinander werden die einzelnen Phasenleiter geprüft, um eine Information über den Fehlerort, d.h. den Phasenbezug zu erhalten.

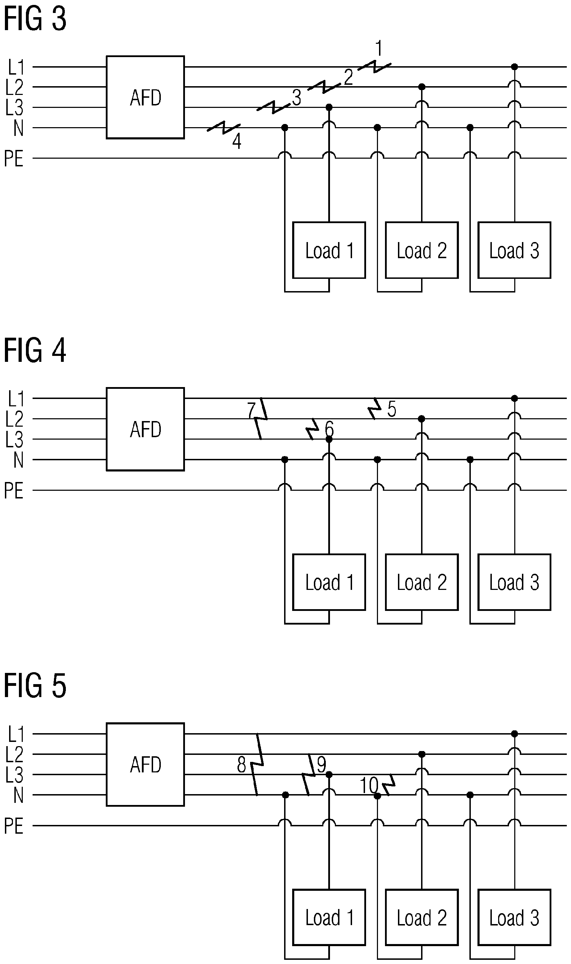

Die Erkennung von seriellen Fehlerlichtbögen ist in der amerikanischen Patentschrift US 5,729,145 beschrieben. Durch Ermittlung des Winkels des Fehlerstroms, z.B. mit Hilfe des Stromsensors SEI und des Spannungsensors SEU, kann der fehlerhafte Leiter identifiziert werden. Zum Beispiel: 0° entspricht Phase L1 (Fall 1), 120° Phase L2 (Fall 2) und 240° Phase L3 (Fall 3). Hinsichtlich der Fälle 1 bis 13 wird auf die Figuren 3 bis verwiesen, die weiter unten erläutert werden. Bei nicht 100%igen ohmschen bzw. resistiven Lasten kann der Phasenwinkel von 0°, 120° oder 240° abweichen. In den meisten Installationen / Stromkreisen wird jedoch ein cos phi > 0.95 angestrebt und die Phasenverschiebungen um die 0°, 120° bzw. 240° sind stark begrenzt. Beispielsweise können Bereiche um die genannten Phasenwinkel definiert sein, zum Beispiel -10° bis +10° für L1, L2 oder/und L3.

Die Erkennung von parallelen Fehlerlichtbögen ist in der deutschen Patentanmeldung DE 10 2010 063 422 A1 beschrieben. Der Phasenwinkel vom Fehlerstrom kann auch ermittelt werden. Ein Phasenwinkel im Bereich -10°/+10° bezogen auf Phase L1 (0°) weist auf einen parallel Fehlerlichtbogen von L1 zu N (Fall 8) oder von L1 zu PE (Fall 11). Die Unterscheidung zwischen diesen 2 Fällen ist nur mit einem 4-poligen AFDD möglich: wenn die Summe aller 4 Strömen Null ergibt, ist Fall 8 eingetreten, ansonsten Fall 11.

Wenn der Winkel sich zwischen den Phasenwinkeln befindet, handelt es sich um einen parallelen Störlichtbogen zwischen 2 Phasen: zum Beispiel 60° entspricht ein Fehlerlichtbogen zwischen L1 und L2.

Die Steuerungseinheit SE ist mit einer Anzeigeeinheit AE verbunden. Diese zeigt bei einem aufgetretenen Fehlerlichtbogen den Fehlerort, d.h. die beteiligte Phase bzw. die beteiligten Phasenleier an.

Die Steuerungseinheit SE kann ferner eine Selbstestfunktion SELF TEST aufweisen.

Die Steuerungseinheit SE gibt bei Ermittlung eines Fehlerlichtbogens ein Fehlerlichtbogenerkennungssignal ab. Beispielsweise an eine Verstärkungseinheit VE, die es verstärkt, und beispielsweise einen spulengesteuerten Stößel SOLENOID auslöst, der über eine Schnittstelle IF, beispielsweise eine mechanische Schnittstelle, eine Auslösung eines Leitungsschutzschalters MCB zur Unterbrechung des Dreiphasenwechselstromkreises bewirkt.

Alternativ kann die Steuerungseinheit SE direkt oder mittels der Verstärkungseinheit VE ein elektrisches Signal direkt an die Schnittstelle IF abgeben, ausgestaltet als elektrische Schnittstelle, das eine Auslösung eines Leitungsschutzschalters MCB, Fehlerstromschutzschalter oder Leistungsschalter bewirkt, so dass eine Unterbrechung des Dreiphasenwechselstromkreises erfolgt.

Alternativ kann im Brandschutzschalter AFD eine Unterbrechungseinheit, beispielsweise mit Kontakten, zur Unterbrechung des elektrischen Stromkreises vorhanden sein, die direkt durch die Steuerungseinheit SE bzw. mittels der Verstärkungseinheit VE oder/und spulengesteuerten Stößel SOLENOID ausgelöst wird.

Der spulengesteuerten Stößel SOLENOID kann ferner mit den Phasenleitern verbunden sein, z.B. für eine weitere Energieversorgung.

Des Weiteren kann am Brandschutzschalter AFD vorbeigeführter Neutralleiter N vorgesehen sein, der mit der Energiesenke bzw. Energieverbraucher LOAD verbunden ist.

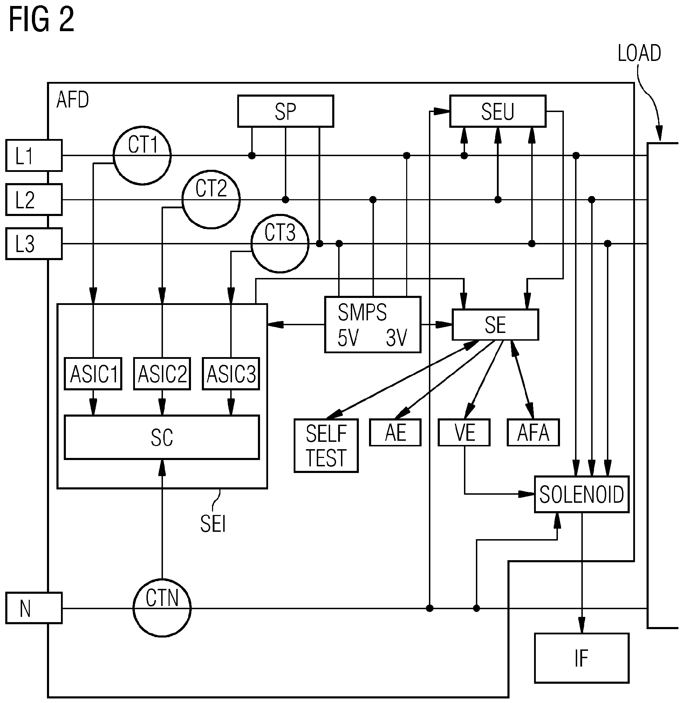

Figur 2 zeigt eine Darstellung gemäß Figur 1, mit dem Unterschied, dass ein Neutralleiter N durch den Brandschutzschalter AFD hindurchgeführt wird. Der Brandschutzschalter weist dazu einen weiteren Anschluss auf. Dem Neutralleiter N ist ebenfalls der Sensoreinheit bzw. Sensorteileinheiten zugeordnet. Beispielsweise ist eine sechste Sensorteileinheit CTN vorgesehen, zur Erfassung von Stromgrößen des Neutralleiters N. Die sechste Sensorteileinheit CTN ist beispielsweise wieder mit der fünften Sensorteileinheit SEI verbunden.

Ferner ist beispielsweise der Neutralleiter mit der vierten Sensorteileinheit SEU verbunden, zur Erfassung von Spannungsgrößen des Neutralleiters.

Desweiteren kann der spulengesteuerten Stößel SOLENOID ferner mit dem Neutralleiter verbunden sein, z.B. für eine weitere Energieversorgung.

Die Figuren 3 bis 6 zeigen auftretende Fehlerszenarien (Fälle) zur Erläuterung der Erfindung.

In den Figuren 3 bis 6 ist jeweils ein erfindungsgemäßer Brandschutzschalter AFD zwischen einer nicht dargestellten Energiequelle mit den Leitern L1, L2, L3, N und PE und den Energiesenken, Energieverbrauchern bzw. Lasten Load 1, Load 2 und Load 3 eingefügt. Die Leiter PE ist ein Schutzleiter respektive Protective Earth des Stromkreises. Er ist in der Regel mit Erde verbunden bzw. weist Erdpotential auf.

Figur 3 zeigt auftretende serielle Fehlerlichtbögen. Mit der Kennziffer 1 (Fall 1) ist ein serieller Fehlerlichtbogen im ersten Phasenleiter L1 dargestellt. Mit der Kennziffer 2 (Fall 2) ist ein serieller Fehlerlichtbogen im zweiten Phasenleiter L2 dargestellt. Mit der Kennziffer 3 (Fall 3) ist ein serieller Fehlerlichtbogen im dritten Phasenleiter L3 dargestellt. Mit der Kennziffer 4 (Fall 4) ist ein serieller Fehlerlichtbogen im Neutralleiter N dargestellt.

Figur 4 zeigt auftretende parallele Fehlerlichtbögen. Mit der Kennziffer 5 (Fall 5) ist ein paralleler Fehlerlichtbogen zwischen erstem Phasenleiter L1 und zweitem Phasenleiter L2 angedeutet. Mit der Kennziffer 6 (Fall 6)ist ein paralleler Fehlerlichtbogen zwischen zweitem Phasenleiter L2 und drittem Phasenleiter L3 angedeutet. Mit der Kennziffer 7 (Fall 7) ist ein paralleler Fehlerlichtbogen zwischen erstem Phasenleiter L1 und drittem Phasenleiter L3 angedeutet.

Figur 5 zeigt weitere auftretende parallele Fehlerlichtbögen.

Mit der Kennziffer 8 (Fall 8) ist ein paralleler Fehlerlichtbogen zwischen erstem Phasenleiter L1 und Neutralleiter N angedeutet. Mit der Kennziffer 9 (Fall 9) ist ein paralleler Fehlerlichtbogen zwischen zweitem Phasenleiter L2 und Neutralleiter N angedeutet. Mit der Kennziffer 10 (Fall 10) ist ein paralleler Fehlerlichtbogen zwischen drittem Phasenleiter L3 und Neutralleiter N angedeutet.

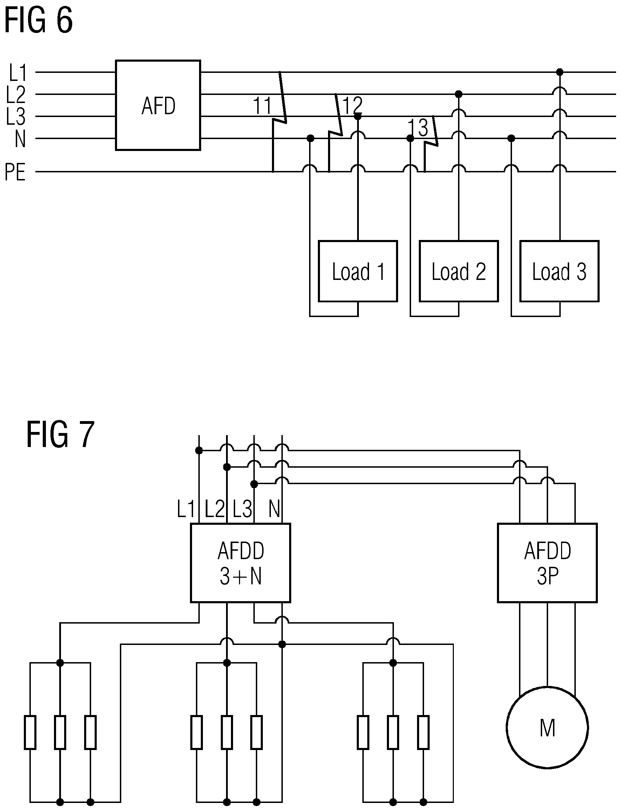

Figur 6 zeigt weitere auftretende parallele Fehlerlichtbögen. Mit der Kennziffer 11 (Fall 11) ist ein paralleler Fehlerlichtbogen zwischen erstem Phasenleiter L1 und Erde / dem Schutzleiter PE angedeutet. Mit der Kennziffer 12 (Fall 12) ist ein paralleler Fehlerlichtbogen zwischen zweitem Phasenleiter L2 und Erde angedeutet. Mit der Kennziffer 13 (Fall 13) ist ein paralleler Fehlerlichtbogen zwischen drittem Phasenleiter L3 und Erde angedeutet.

Erfindungsgemäß ist eine Anzeigeeinheit vorgesehen, die zumindest teilweise den Fehlerort anzeigt. Bei einem rein dreiphasigen Brandschutzschalter, bei dem nur die drei Phasenleiter durch das Gerät geführt sind, zumindest ein Bezug hinsichtlich der betroffenen Phasenleiter.

Bei einem vierpoligen Brandschutzschalter, auch als 3+N bezeichnet, hinsichtlich der 4 Leiter. Bei einem Gerät mit Erdbezug bzw. Schutzleiter, auch hinsichtlich Erde.

Bei einem vierpoligen Brandschutzschalter kann auch ein Bezug hinsichtlich der 4 Leiter und zudem für parallele Fehlerlichtbögen hinsichtlich einer Phase und Erde oder dem Schutzleiter PE angezeigt werden.

Es kann natürlich in einem vierpoligen Gerät auch nur der Phasenbezug (kein Neutralleiterbezug) angezeigt werden, d.h. weniger als möglich signalisiert werden.

Dies kann beispielsweise durch mindestens drei am Brandschutzschalter AFD vorgesehen Lichtemitterdioden erfolgen. Hierbei ist jeweils eine Lichtermitterdiode/LED einer Phase zugeordnet. Leuchtet nur eine Lichtemitterdiode, ist ein Fehlerlichtbogen in der Phase festgestellt worden. Hierbei handelt es sich in aller Regel um einen seriellen Lichtbogen. Leuchten zwei LED, ist ein Fehlerlichtbogen in den jeweiligen Phasenleitern festgestellt werden. Hierbei kann es sich um zwei serielle oder, mit höherer Wahrscheinlichkeit, einen parallelen Lichtbogen zwischen den beiden Phasenleitern handeln.

Alternativ sind in einem vierpoligen Brandschutzschalter 4 oder 5 LED vorgesehen, die vierte LED für den Neutralleiter. Die fünfte LED gegebenenfalls für den Erdbezug.

In einem dreipoligen Brandschutzschalter, d.h. der nur die 3 Phasenleiter führt, können beispielsweise 6 LED vorgesehen sein. Hiervon signalisieren 3 LED serielle Lichtbögen im jeweiligen Phasenleiter; die 3 weiteren LED parallele Lichtbögen, jeweils zwischen L1-L2, L2-L3 bzw. L1-L3.

In einem vierpoligen Brandschutzschalter, der die 3 Phasenleiter und den Neutralleiter führt, können 10 LED vorgesehen sein. Jeweils 4 LED für serielle Lichtbögen in L1, L2, L3 oder N. Jeweils 6 LED für parallele Lichtbögen zwischen L1-L2, L2-L3, L1-L3, L1-N, L2-N, L3-N.

In einem vierpoligen Brandschutzschalter mit Erdbezug können 13 LED vorgesehen sein. Jeweils 4 LED für serielle Lichtbögen in L1, L2, L3 oder N. Jeweils 9 LED für parallele Lichtbögen zwischen L1-L2, L2-L3, L1-L3, L1-N, L2-N, L3-N, L1-Erde, L2-Erde, L1-Erde.

Somit ist eine direkte Anzeige und Ablesbarkeit des Fehlerortes und der Fehlerart gegeben. Die Steuereinheit, aufweisend beispielsweise einen Mikroprozessor, ist entsprechend ausgelegt die Fehlerart (seriell, parallel) mit auszugeben, beispielsweise durch Ausgabe den entsprechenden Algorithmus, um serielle oder parallele Fehlerlichtbögen zu erkennen.

Alternativ kann die Anzeige auch durch mindestens eine, insbesondere zwei, Siebensegmentanzeigen erfolgen. Dabei kann beispielsweise die Nummer des Fehlers angezeigt werden, wobei jeder Nummer (1 bis 13) eine entsprechende Fehlerart und Fehlerort (Leiterbezug), wie beispielsweise oben dargestellt, zugeordnet ist.

Alternativ kann die Anzeige über ein LCD Display erfolgen.

Somit ist ein Brandschutzschalter um eine hilfreiche und praktische Funktionalität erweitert. Eine Fehlersuche kann schneller erfolgen.

Im Folgenden wird die Erfindung nochmals dargestellt. Zusätzlich zu einer möglichen Statusanzeige des Brandschutzschalters wird nun die Fehlerart bzw. der Fehlerort angezeigt. Die Steuerungseinheit, beispielsweise mit Mikrocontroller, liefert dabei die Information, ob aufgrund eines seriellen oder parallelen Fehlerlichtbogens ausgelöst wurde bzw. wo der Fehler aufgetreten ist (L1, L2, L3, N, Erde).

Bezüglich Fehlerort und Fehlerart kann es insgesamt 13 verschiedene Anzeigemöglichkeiten geben. Hierbei 4 bei seriellen Lichtbögen und 9 bei parallelen, siehe Figuren 3 bis 6.

Jedem Fehler kann eine Zahl (=Fehlercode) von 1 bis 13 zugeordnet werden. So entspricht jede Zahl einer Kombination aus Fehlerort und Fehlerart. Nach beispielsweise einem Reset des Brandschutzschalters wird z.B. über zwei 7-Segment Displays der Fehlercode angezeigt. Alternativ ist auch die Anzeige über ein einzelnes 7-Segement Display, bei dem 0 der Zahl 10 entspricht und die Zahlen 11-13 über eine spezielle Codierung, wie z.B. die beiden linken Striche für 11, die drei waagrechten Striche für 12 und ein "E" für 13, angezeigt werden.

Alternativ kann die Anzeige mittels eines LED-Bandes aus, je nach Anwendungsfall, bis zu 13 LEDs (jede LED repräsentiert eine Nummer) erfolgen. Alternativ können auch 4 LED verwendet werden, wobei der Fehlercode als Binärzahl angezeigt wird. Alternativ kann die Ausgabe auch durch einen Near Field Kommunkation, kurz NFC, beispielsweise mittels eines NFC-Moduls, z.b. mit NFC-Chip erfolgen, wobei die Information z.B. über ein Mobiltelefon auslesbar ist.

Alternativ kann eine kabelgebundene Schnittstelle, wie z.B. I2C, Bus, Ethernet, etc., vorgesehen sein.

Alternativ auch eine kabellose Schnittstelle, wie WLAN, Infrarot, Bluetooth, etc., vorgesehen sein.

Die Anzeige kann auch durch LEDs mittels eines speziellen "Blinkcodes" erfolgen.

Der Vorteil der Erfindung besteht darin, einen Brandschutzschalte nicht nur auf eine Fehlererkennung und Auslösung / Nicht-Auslösung zu beschränken, sondern mit Hilfe der Steuerungseinheit und einer erfindungsgemäßen Anzeige, nebst entsprechender Algorithmen, wichtige Informationen über Fehlerart (paralleler oder serieller Lichtbogen) sowie Fehlerort (L1, L2, L3, N) anzuzeigen, so dass Kunden einen weiteren, bisher nicht zur Verfügung stehenden, Nutzen haben.

Der Vorteil für Betreiber bzw. Kunden ergibt sich durch die Information, in welcher Phase er nach einem Fehler suchen muss bzw. nach welchem Fehler er suchen muss (Unterschied zwischen parallelen und seriellen Lichtbögen).

In Figur 7 ist eine Anwendung der erfindungsgemäßen Brandschutzschalter gezeigt. Figur 7 zeigt elektrische Dreiphasenwechselstromkreise, wobei einerseits ein so genanntes Brandschutzschalter Upstream-Gerät AFDD 3+N mehrere Energiesenken/Verbraucher absichert und andererseits ein so genanntes Brandschutzschalter Downstream-Gerät AFDD 3P einen Motor M als Energiesenke/Verbraucher absichert.

In Figur 7 kann durch dieses Brandschutzschalter Upstream-Gerät AFDD 3+N beispielsweise eine Küche (über L1), ein Wohnzimmer (über L2) und ein Schlafzimmer (über L3) versorgt werden. Löst der AFDD ohne eine Anzeige des Fehlerorts aus, muss der Kunde in allen 3 Zimmern nach einem Fehler suchen. Durch eine Anzeige des Fehlerorts kann der Kunde gezielt in einem der drei Zimmer suchen bzw. durch Abschalten des Stroms in diesem Zimmer die Spannungsversorgung in den beiden anderen wieder sicherstellen. Lange Ausfallzeiten und eine aufwändige Fehlersuche können somit reduziert werden.

Beim Brandschutzschalter Downstream-Gerät AFDD 3P wird ebenfalls die Fehlerart und der Fehlerort angegeben werden, wobei auf Grund der 3 Phasenleiter der Fehlerumfang beschränkt ist.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Brandschutzschalter (AFD) für einen elektrischen Dreiphasenwechselstromkreis, wobei der Dreiphasenwechselstromkreis 3 Phasenleiter (L1, L2, L3) und einen Neutralleiter (N) aufweist, der Brandschutzschalter (AFD) aufweisend,
- jeweils einen Anschluss für jeden der 3 Phasenleiter (L1, L2, L3) und einen Anschluss zum Hindurchführen des Neutralleiters(N) durch den Brandschutzschalter (AFD),
- eine den 3 Phasenleitern und dem Neutralleiter (N) zugeordnete Sensoreinheit zur Erfassung von Stromgrößen und Spannungsgrößen des Dreiphasenwechselstromkreises, wobei die Sensoreinheit Stromgrößen und Spannungsgrößen des Neutralleiters (N) erfasst,
- eine mit der Sensoreinheit verbundene Steuerungseinheit (SE), zur Auswertung der elektrischen Größen und Ermittlung eines seriellen oder/und parallelen Fehlerlichtbogens sowie Abgabe eines Fehlerlichtbogenerkennungssignals zur Unterbrechung des elektrischen Dreiphasenwechselstromkreises, **dadurch gekennzeichnet, dass** die Steuerungseinheit (SE) eine Fehlerlichtbogenerkennungsfunktion (AFA) zur Ermittlung der Fehlerart und des Fehlerorts etwaiger serieller und/oder paralleler Fehlerlichtbögen aus den ermittelten Strom- und Spannungsgrößen aufweist,
- wobei die Steuerungseinheit (SE) dafür ausgestaltet ist, für einen Fehlerlichtbogen die Fehlerart und den Fehlerort einer einzigen Kennziffer zuzuordnen,
- eine Anzeigeeinheit (AE), die derart ausgestaltet ist, dass bei einem aufgetretenen Fehlerlichtbogen die Fehlerart und ein Phasenbezug und/oder ein Neutralleiterbezug des aufgetretenen Fehlerlichtbogens mittels der zugeordneten Kennziffer angezeigt werden.

2. Brandschutzschalter (AFD) nach Patentanspruch 1,
wobei der Dreiphasenwechselstromkreis einen Schutzleiter (PE) aufweist, der mit Erde verbunden werden kann,
**dadurch gekennzeichnet,**
**dass** die Steuerungseinheit (SE) derart ausgestaltet ist, dass ein Fehlerlichtbogen gegen Erde ermittelbar ist und
**dass** die Anzeigeeinheit derart ausgestaltet ist, dass ein Erdbezug des aufgetretenen Fehlerlichtbogens anzeigbar ist.

3. Brandschutzschalter (AFD) nach Patentanspruch 1 oder 2 , **dadurch gekennzeichnet,**
**dass** die Anzeigeeinheit (AE) derart ausgestaltet ist, dass mindestens 3 LEDs vorgesehen sind, insbesondere 4, 5, 6, 10 oder 13 LED vorgehsehen sind, mittels denen der Leiter- bzw. Erdbezug angezeigt wird.

4. Brandschutzschalter (AFD) nach Patentanspruch 1 oder 2 , **dadurch gekennzeichnet,**
**dass** die Anzeigeeinheit (AE) derart ausgestaltet ist, dass mindestens eine, insbesondere zwei, Siebensegmentanzeigen vorgesehen sind, mittels denen der Bezug angezeigt wird.

5. Brandschutzschalter (AFD) nach Patentanspruch 1 oder 2, **dadurch gekennzeichnet,**
**dass** die Anzeigeeinheit (AE) derart ausgestaltet ist, dass ein LCD Display vorgesehen ist, mittels dem der Bezug angezeigt wird.

6. Brandschutzschalter (AFD) nach einem der vorhergehenden Patentansprüche,
**dadurch gekennzeichnet,**
**dass** eine Unterbrechungseinheit mit Kontakten vorgesehen ist, die bei einem Fehlerlichtbogenerkennungssignal den elektrischen Dreiphasenwechselstromkreis unterbricht.

7. Verfahren für einen elektrischen Dreiphasenwechselstromkreis mit 3 Phasenleitern und einem Neutralleiter, bei dem
- Stromgrößen und Spannungsgrößen des Dreiphasenwechselstromkreises erfasst werden, wobei Stromgrößen und Spannungsgrößen des Neutralleiters erfasst werden, und die erfassten Stromgrößen und Spannungsgrößen hinsichtlich des Vorliegens eines seriellen oder/und parallelen Fehlerlichtbogens ausgewertet werden,
- zur Ermittlung etwaiger serieller und/oder paralleler Fehlerlichtbögen aus den erfassten Strom- und Spannungsgrößen eine Fehlerlichtbogenerkennungsfunktion eingesetzt wird,
- bei Vorliegen eines Fehlerlichtbogens ein Fehlerlichtbogenerkennungssignals zur Unterbrechung des elektrischen Dreiphasenwechselstromkreises abgegeben wird,
- wobei eine Auswertung hinsichtlich des Leiterbezuges durchgeführt wird,
- wobei für den Fehlerlichtbogen die Fehlerart und den Fehlerort einer Kennziffer zugeordnet wird,
- die Fehlerart und ein Phasenbezug und/oder ein Neutralleiterbezug des aufgetretenen Fehlerlichtbogens mittels der zugeordneten Kennziffer angezeigt werden.

## Claims

1. Arc fault detection device (AFD) for an electrical three-phase AC circuit, wherein the three-phase AC circuit has three phase conductors (L1, L2, L3) and a neutral conductor (N), the arc fault detection device (AFD) having
- a respective connection for each of the three phase conductors (L1, L2, L3) and a connection for guiding the neutral conductor (N) through the arc fault detection device (AFD),
- a sensor unit which is assigned to the three phase conductors and to the neutral conductor (N) and is intended to capture current variables and voltage variables of the three-phase AC circuit, wherein the sensor unit captures current variables and voltage variables of the neutral conductor (N),
- a control unit (SE) which is connected to the sensor unit and is intended to evaluate the electrical variables and determine a series or/and parallel arcing fault and to output an arcing fault detection signal for the purpose of interrupting the electrical three-phase AC circuit, **characterized in that**
the control unit (SE) has an arcing fault detection function (AFA) for determining the fault type and the fault location of any series and/or parallel arcing faults from the determined current and voltage variables,
- wherein the control unit (SE) is configured to assign the fault type and the fault location to a single code number for an arcing fault,
- a display unit (AE) which is configured such that, if an arcing fault has occurred, the fault type and a phase reference and/or a neutral conductor reference of the arcing fault that has occurred are displayed by means of the assigned code number.

2. Arc fault detection device (AFD) according to Patent Claim 1,
wherein the three-phase AC circuit has a protective conductor (PE) which can be connected to earth,
**characterized**
**in that** the control unit (SE) is configured such that an arcing fault to earth can be determined, and
**in that** the display unit is configured such that an earth reference of the arcing fault that has occurred can be displayed.

3. Arc fault detection device (AFD) according to Patent Claim 1 or 2,
**characterized**
**in that** the display unit (AE) is configured such that at least three LEDs are provided, in particular 4, 5, 6, 10 or 13 LEDs, which are used to display the conductor or earth reference.

4. Arc fault detection device (AFD) according to Patent Claim 1 or 2,
**characterized**
**in that** the display unit (AE) is configured such that at least one, in particular two, seven-segment displays are provided and are used to display the reference.

5. Arc fault detection device (AFD) according to Patent Claim 1 or 2,
**characterized**
**in that** the display unit (AE) is configured such that an LCD display is provided and is used to display the reference.

6. Arc fault detection device (AFD) according to one of the preceding patent claims,
**characterized**
**in that** an interruption unit having contacts is provided and interrupts the electrical three-phase AC circuit in the event of an arcing fault detection signal.

7. Method for an electrical three-phase AC circuit having three phase conductors and a neutral conductor, in which
- current variables and voltage variables of the three-phase AC circuit are captured, wherein current variables and voltage variables of the neutral conductor are captured, and the capture current variables and voltage variables are evaluated with respect to the presence of a series or/and parallel arcing fault,
- an arcing fault detection function is used to determine any series and/or a parallel arcing faults from the captured current and voltage variables,
- an arcing fault detection signal is output when an arcing fault is present for the purpose of interrupting the electrical three-phase AC circuit,
- wherein an evaluation with respect to the conductor reference is carried out,
- wherein the fault type and the fault location are assigned to a code number for the arcing fault,
- the fault type and a phase reference and/or a neutral conductor reference of the arcing fault that has occurred are displayed by means of the assigned code number.

## Revendications

1. Commutateur de protection contre l'incendie (AFD) pour un circuit électrique alternatif triphasé, dans lequel le circuit électrique alternatif triphasé comprend 3 conducteurs de phase (L1, L2, L3) et un conducteur neutre (N), le commutateur de protection contre l'incendie (AFD) comprenant :
- une borne pour chacun des 3 conducteurs de phase (L1, L2, L3) et une borne pour le passage du conducteur neutre (N) à travers le commutateur de protection contre l'incendie (AFD),
- une unité de détection associée aux 3 conducteurs de phase et au conducteur neutre (N) pour la saisie des grandeurs de courant et des grandeurs de tension du circuit électrique alternatif triphasé, dans lequel l'unité de détection saisit des grandeurs de courant et des grandeurs de tension du conducteur neutre (N),
- une unité de commande (SE) reliée à l'unité de détection, pour l'évaluation des grandeurs électriques et la détermination d'un arc électrique de défaut en série et/ou en parallèle ainsi que l'émission d'un signal de détection d'arc électrique de défaut pour la coupure du circuit électrique alternatif triphasé, **caractérisé en ce que** l'unité de commande (SE) présente une fonction de détection d'arc électrique de défaut (AFA) pour la détermination du type de défaut et du lieu de défaut d'éventuels arcs électriques de défaut en série et/ou en parallèle à partir des grandeurs de courant et de tension déterminées,
- dans lequel l'unité de commande (SE) est conçue pour attribuer le type de défaut et le lieu du défaut à un seul chiffre caractéristique pour un arc électrique de défaut,
- une unité d'affichage (AE) qui est conçue de telle sorte qu'en cas d'apparition d'un arc électrique de défaut, le type de défaut et une référence de phase et/ou une référence de conducteur neutre de l'arc électrique de défaut survenu sont affichés au moyen du chiffre caractéristique attribué.

2. Commutateur de protection contre l'incendie (AFD) selon la revendication 1, dans lequel le circuit électrique alternatif triphasé comprend un conducteur de protection (PE) qui peut être relié à la terre, **caractérisé en ce que** l'unité de commande (SE) est conçue de telle sorte qu'un arc électrique de défaut puisse être détecté par rapport à la terre et l'unité d'affichage est conçue de telle sorte qu'une référence de la terre de l'arc électrique de défaut qui est survenu puisse être affichée.

3. Commutateur de protection contre l'incendie (AFD) selon la revendication 1 ou 2, **caractérisé en ce que** l'unité d'affichage (AE) est conçue de telle sorte qu'il soit prévu au moins 3 LED, en particulier 4, 5, 6, 10 ou 13 LED, au moyen desquelles la référence du conducteur ou de la terre est affichée.

4. Commutateur de protection contre l'incendie (AFD) selon la revendication 1 ou 2, **caractérisé en ce que** l'unité d'affichage (AE) est conçue de telle sorte qu'au moins un, en particulier deux, affichages à sept segments soient prévus, au moyen desquels la référence est affichée.

5. Commutateur de protection contre l'incendie (AFD) selon la revendication 1 ou 2, **caractérisé en ce que** l'unité d'affichage (AE) est conçue de telle sorte qu'un écran LCD soit prévu, au moyen duquel la référence est affichée.

6. Commutateur de protection contre l'incendie (AFD) selon l'une des revendications précédentes, **caractérisé en ce qu'**il est prévu une unité de coupure avec des contacts qui, en cas de signal de détection d'un arc électrique de défaut, coupe le circuit électrique alternatif triphasé.

7. Procédé pour un circuit électrique alternatif triphasé comprenant 3 conducteurs de phase et un conducteur neutre, dans lequel
- des grandeurs de courant et des grandeurs de tension du circuit électrique alternatif triphasé sont saisies, des grandeurs de courant et des grandeurs de tension du conducteur neutre sont saisies, et les grandeurs de courant et les grandeurs de tension saisies sont évaluées pour déterminer la présence d'un arc électrique de défaut en série et/ou en parallèle,
- une fonction de détection d'arcs électriques de défaut est utilisée pour déterminer d'éventuels arcs électriques de défaut en série et/ou en parallèle à partir des grandeurs de courant et de tension saisies,
- en présence d'un arc électrique de défaut, un signal de détection d'arc électrique de défaut est émis pour la coupure du circuit électrique alternatif triphasé,
- dans lequel une évaluation de la référence du conducteur est effectuée,
- dans lequel le type de défaut et le lieu du défaut sont attribués à un chiffre caractéristique pour l'arc électrique de défaut,
- le type de défaut et une référence de phase et/ou une référence de conducteur neutre de l'arc électrique de défaut apparu sont indiqués au moyen du chiffre caractéristique attribué.
